# EUROPÄISCHE PATENTSCHRIFT

(11) **EP 0 492 256 B1**
(45) Veröffentlichungstag und Bekanntmachung des Hinweises auf die Patenterteilung: **14.08.1996**
(21) Anmeldenummer: 91121088.8
(22) Anmeldetag: 09.12.1991
(51) Int. Cl.: G03F 7/38

(54) **Photolithographische Strukturerzeugung**
Photolithographic patterning
Création de structure par voie photolithographique

(30) Priorität: 20.12.1990 DE 4041002
(43) Veröffentlichungstag der Anmeldung: 01.07.1992
(73) Patentinhaber: SIEMENS AKTIENGESELLSCHAFT, 80333 München (DE)
(72) Erfinder: Sezi, Recai, Dr., W-8551 Röttenbach (DE); Borndörfer, Horst, Dipl.-Chem., W-8520 Erlangen (DE); Leuschner, Rainer, Dr., W-8520 Erlangen (DE); Sebald, Michael, Dr., W-8521 Hessdorf-Hannberg (DE); Birkle, Siegfried, Dr., W-8552 Höchstadt (DE); Ahne, Hellmut, Dr., W-8551 Röttenbach (DE)

(56) Entgegenhaltungen:
- EP-A- 0 102 450
- EP-A- 0 394 740
- US-A- 4 508 812

## Beschreibung

Die Erfindung betrifft ein Verfahren zur photolithographischen Strukturerzeugung im Submikron-Bereich.

Bei der photolithographischen Strukturerzeugung zeigen trockenentwickelbare TSI-Einlagenresists (TSI = Top Surface Imaging) die Vorzüge von Zweilagenresists (mit Naßentwicklung des Topresists und Trockenentwicklung des Bottomresists), wie Unterdrükkung von Reflexionen und Verringerung der Topographieeffekte. Darüber hinaus bieten sie den zusätzlichen Vorteil, daß auf das Substrat, im allgemeinen ein Siliciumwafer, nur eine einzige Resistschicht aufgebracht werden muß und die Naßentwicklung entfällt. Eine detaillierte Beschreibung von Systemen der genannten Art findet sich in "Introduction to Microlithography", ACS Symposium Series 219 (1983), Seiten 287 bis 350.

TSI-Resists sind sowohl in Form positiv arbeitender als auch in Form negativ arbeitender, trockenentwickelbarer Einlagensysteme bekannt. Im Gegensatz zu negativ arbeitenden Systemen sind positiv arbeitende TSI-Systeme - wegen einer geringeren Defektdichte - viel besser für Anwendungen in den Kontaktlochebenen, die sehr kritisch sind, geeignet.

Trockenentwickelbare Einlagensysteme arbeiten nach folgendem Prinzip:
- Aufbringen des Resists auf einen Siliciumwafer;
- Belichten und gegebenenfalls Aufheizen, um ein "latentes" Bild zu erzeugen;
- Behandeln mit einem Metallisierungsagens, beispielsweise einer Organometallverbindung, wodurch der Resist - in den belichteten Bereichen (Negativresist) oder in den unbelichteten Bereichen (Positivresist) - resistent wird gegen Trockenentwicklung, insbesondere im Sauerstoffplasma;
- Trockenentwickeln.

Diese Anzahl von Prozeßschritten soll bei der Produktion nicht überschritten werden.

Ein produktionstaugliches hochauflösendes TSI-System soll darüber hinaus folgenden Anforderungen genügen:
1. Einfache und linienkompatible Prozessierung
   Mehr Prozeßschritte als die vorstehend genannten bedeuten einen höheren Kostenaufwand, wobei die Mehrkosten durch Investitionen für zusätzliche Geräte und/oder Reagenzien sowie durch Fehlerquellen aufgrund der zusätzlichen Prozeßschritte, die eine geringere Ausbeute bedingen, verursacht sein können.
2. Hohe Empfindlichkeit
   Um so geringer die Empfindlichkeit ist, um so geringer ist der Durchsatz bei den teuren Steppern und um so höher sind die Kosten. Dabei ist insbesondere eine hohe Empfindlichkeit im DUV-Bereich (DUV = Deep UV), beispielsweise bei 248 nm, wichtig, da die Auflösung mit abnehmender Wellenlänge steigt.
3. Hohe Resistenz gegen Plasmaentwicklung bzw. restefreie Entwickelbarkeit
   Eine hohe Resistenz der mit dem Metallisierungsagens behandelten Bereiche ist für einen hohen Prozeßspielraum beim Trockenentwickeln wichtig, eine restefreie Entwickelbarkeit für die Ausbeute. Um eine restefreie Entwickelbarkeit zu erreichen, ist manchmal ein Zweistufen-Ätzprozeß erforderlich, wobei zuerst in einem halogenhaltigen Plasma und dann in einem Sauerstoffplasma entwickelt wird. Dies wiederum setzt eine sehr hohe Ätzstabilität der mit dem Metallisierungsagens behandelten Schichtbereiche voraus.

Um das Problem einer geringen DUV-Empfindlichkeit von Photoresists zu lösen, wurden Resistsysteme entwickelt, deren Basispolymer tert.-Butylester- oder tert.-Butoxycarbonyloxy-Gruppen aufweist (siehe dazu EP-OS 0 102 450 und 0 161 476 bzw. die entsprechenden US-Patentschriften 4 491 628 und 4 552 833). Beim Belichten in Gegenwart eines starken Säurebildners, beispielsweise eines sogenannten Crivellosalzes, werden dabei Carboxyl- bzw. phenolische OH-Gruppen erzeugt, wobei ein einziges Proton - nach dem Prinzip der sogenannten chemischen Verstärkung ("chemical amplification") - mehrere Gruppen abspaltet (siehe dazu beispielsweise "J. Electrochem. Soc.", Vol. 136 (1989), Seiten 1453 bis 1456).

Es sind bereits mehrere TSI-Systeme bekannt, die aber den vorstehend genannten Anforderungen jeweils nicht vollständig genügen:
- EP-OS 0 136 130
   Mit dem beschriebenen Verfahren können - mit UV-Licht oder Elektronenstrahlen - positive und negative Strukturen erzeugt werden. Von Nachteil ist der Bedarf an speziellen Apparaturen (für Vakuum) sowie das Erfordernis einer Metallisierung mit korrosiven bzw. toxischen Gasen, wie B₂H₆, SiCl₄ und TiCl₄, was für die Fertigung wenig geeignet ist.
- EP-OS 0 192 078 (bzw. US-PS 4 551 418)
   Es wird ein Verfahren zur Erzeugung einer negativen Resiststruktur beschrieben, bei dem ein Basispolymer verwendet wird, das einen kationischen Photoinitiator enthält, insbesondere ein Triarylsulfoniumsalz oder ein trihalogeniertes Methyltriazin. Nach der Belichtung wird dabei die Resistschicht mit einem kationisch polymerisierbaren Monomer, wie Epoxysiloxan und -silan oder Styrolsilylether, behandelt (in der Gasphase oder in Lösung), um einen Polymerfilm zu bilden, der die belichteten Bereiche beim nachfolgenden Plasmaätzprozeß schützt.
- EP-OS 0 204 253 (bzw. US-PS 4 613 398)
   Es werden positiv und negativ arbeitende Systeme beschrieben, wobei die Permeabilität des Resists gegenüber dem Metallisierungsagens durch die Belichtung verändert wird. Nachteil dieses Systems im Positivmode sind eine geringe DUV-Empfindlichkeit (50 bis 300 mJ/cm²) und das Erfordernis einer Silylierung mit Hexamethylcyclotrisilazan in o-Xylol bei 65°C, wozu eine spezielle Apparatur erforderlich und somit ein geringe Linienkompatibilität gegeben ist.
- EP-OS 0 229 917 (bzw. US-PS 4 657 845)
   Es wird ein Verfahren beschrieben, das auf dem Prinzip der chemischen Verstärkung beruht und eine hohe DUV-Empfindlichkeit aufweist (ca. 6 mJ/cm²). Hierbei werden aber zwei zusätzliche Prozeßschritte benötigt, nämlich eine metallfreie Behandlung mit Methylisocyanat, und zwar im Vakuumofen, sowie eine Flutbelichtung.
- EP-OS 0 248 779
   Das beschriebene Verfahren kommt zwar mit wenigen Prozeßschritten aus, es wird jedoch eine spezielle Apparatur für eine Gasphasensilylierung bei erhöhter Temperatur benötigt. Außerdem besitzt das dabei eingesetzte System aus Polyvinylphenol und Bisazid keine hohe DUV-Empfindlichkeit. Entsprechendes gilt auch für ein aus der EP-OS 0 318 956 bekanntes System.
- EP-OS 0 281 182 und EP-OS 0 352 739 (bzw. US-PS 4 921 778)
   Die beschriebenen Systeme weisen zwar eine gute DUV-Empfindlichkeit auf, sie haben aber den Nachteil, daß spezielle Apparaturen für eine Silylierung aus der Gasphase bei erhöhter Temperatur erforderlich sind. Außerdem weisen die silylierten Bereiche - aufgrund des Einbaus von monomeren Siliciumfragmenten, wie Si(CH₃)₃-Gruppen - nur eine mäßige Ätzresistenz auf (siehe dazu auch: "Microelectronic Engineering", Vol. 3 (1985), Seiten 279 bis 291).
- "Mat. Res. Soc. Symp. Proc.", Vol. 45 (1985), Seiten 197 bis 202, sowie "IBM Techn. Discl. Bull.", Vol. 27, No. 4A (1984), Seite 2197
   Das beschriebene Verfahren basiert auf der Decarboxylierung von Homo- oder Copolymeren von (Meth)acrylsäure, und gegebenenfalls dessen Anhydrid, durch energiereiche Strahlung und Silylierung der unbelichteten Bereiche aus der Gasphase. Die Nachteile bestehen in der Gasphasensilylierung (Erfordernis von speziellem Equipment), der relativ geringen Ätzresistenz im Sauerstoffplasma (aufgrund einer Silylierung mit Hexamethyldisilazan) und der DUV-Unempfindlichkeit einer Decarboxylierungsreaktion der genannten Art.

Es wurde ferner bereits ein Strukturierungsverfahren mit Trokkenentwicklung vorgeschlagen, das positive Bilder liefert, wobei - unter Verwendung üblicher Apparaturen - Subhalbmikron-Strukturen erzeugt werden können (siehe: europäische Patentanmeldung Nr. 90107013.6 (≙ EP-A-0 451 311). Dieses Verfahren beinhaltet aber zwei zusätzliche Prozeßschritte, nämlich eine Behandlung der belichteten Photoresistschicht mit einer polyfunktionellen organischen Verbindung, insbesondere einem Polyamin, und eine Flutbelichtung.

Außerdem wurde bereits ein Verfahren vorgeschlagen, mit dem - unter Verwendung eines trockenentwickelbaren Resistsystems - hochaufgelöste negative Resiststrukturen mit steilen Flanken erhalten, wergen könn n (siehe: europäische Patentanmeldung Nr. 90108062.2 ≙EP-A-0 453 610). Das Resistsystem basiert dabei auf einem Polymer, das Anhydridgruppen sowie blockierte Imid- oder phenolische Hydroxylgruppen aufweist, und einem Säurebildner. Dieses System, das nach dem Prinzip der chemischen Verstärkung arbeitet, weist zwar - insbesondere im DUV-Bereich (beispielsweise bei einer Belichtung bei 248 nm) - eine höhere Empfindlichkeit auf als vergleichbare bekannte Systeme (siehe: EP-OS 0 394 740), es genügt dennoch den neuesten strengen Anforderungen der Produktion nicht ganz. Hiernach sollte die Empfindlichkeit nämlich besser sein als 20 mJ/cm², gemessen an Steppern mit einem KrF-Excimerlaser als Lichtquelle (nicht an Kontaktbelichtungsgeräten mit Hg/Xe-Lampe, die mindestens eine um den Faktor 4 bessere Empfindlichkeit vortäuschen).

Aufgabe der Erfindung ist es, ein Verfahren zur photolithographischen Erzeugung hochaufgelöster Strukturen (Subhalbmikron-Bereich) mit steilen Flanken bzw. ein dafür geeignetes trockenentwickelbares TSI-Resistsystem bereitzustellen, das einfach prozessierbar ist, eine hohe Ätzresistenz besitzt und eine hohe Empfindlichkeit aufweist (< 20 mJ/cm²), insbesondere im DUV-Bereich. Dabei soll der Metallisierungsprozeß, d.h. die Silylierung, bei Normalbedingungen in produktionsüblichen Geräten durchgeführt werden können.

Dies wird erfindungsgemäß dadurch erreicht, daß
- auf ein Substrat eine Photoresistschicht aus einem Carbonsäureanhydrid- und CarbonsäureCarbonsäure-tert.-butylestergruppen enthaltenden Polymer, einem bei Belichtung eine Säure freisetzenden Photoinitiator und einem geeigneten Lösungsmittel aufgebracht wird,
- die Photoresistschicht getrocknet wird,
- die Photoresistschicht bildmäßig belichtet wird,
- die belichtete Photoresistschicht einer Temperaturbehandlung ausgesetzt wird,
- die derart behandelte Photoresistschicht einer Flüssigsilylierung unterworfen wird und
- die silylierte Photoresistschicht in einem anisotropen Sauerstoffplasma, d.h. in einem sauerstoffhaltigen Plasma, trocken entwickelt wird,
wobei die Temperaturbehandlung so geführt wird, daß der Photoresist in den belichteten Bereichen hydrophil wird.

Beim erfindungsgemäßen Verfahren sind insbesondere folgende Punkte von Bedeutung:
- Der eingesetzte Photoresist weist ein spezielles Basispolymer auf, nämlich ein Polymer, das Carbonsäureanhydrid- und Carbonsäure-tert.-butylestergruppen besitzt. Dabei sollte eine Ätzresistenz gegen Substratätzprozesse gegeben sein, d.h. der Resist enthält vorzugsweise aromatische Gruppierungen.
- Die Temperaturbehandlung ("post exposure bake") erfolgt in der Weise, daß der Resist in den belichteten Bereichen hydrophil wird. Bei diesem Schritt erfolgt nämlich in den belichteten Bereichen - durch die bei der Belichtung photochemisch erzeugte Säure - eine säurekatalysierte Esterspaltung, d.h. eine Abspaltung der tert.-Butylgruppen, wobei freie Carbonsäuregruppen gebildet werden.
- Die Silylierung erfolgt in flüssiger Phase bei Normalbedingungen, d.h. bei Raumtemperatur und Normaldruck, in üblichen Sprüh- bzw. Puddle-Entwicklungsapparaturen.

Um die säurekatalysierte Abspaltung der tert.-Butylgruppen zu bewirken, wird beim erfindungsgemäßen Verfahren die Temperaturbehandlung vorteilhaft bei Temperaturen zwischen 80 und 140°C, insbesondere bei 110 bis 120°C, durchgeführt. Die Dauer der Temperaturbehandlung beträgt vorzugsweise 15 bis 200 s, insbesondere etwa 60 s. Diese Werte gelten vor allem bei der Verwendung einer Hotplate. Erfolgt die Temperaturbehandlung in anderer Weise, beispielsweise in einem Umluftofen, dann können durchaus auch höhere Temperaturen und/oder längere Behandlungszeiten erforderlich sein.

Durch die Flüssigsilylierung wird beim erfindungsgemäßen Verfahren eine Ätzresistenz gegen Trockenentwicklung im Sauerstoffplasma bewirkt. Dabei wird durch die Art der Silylierungslösung bestimmt, ob die unbelichteten, hydrophoben Bereiche der Resistschicht oder die belichteten, hydrophilen Bereiche selektiv silyliert werden. Bei der Erzeugung positiver Strukturen erfolgt die Flüssigsilylierung mit einer unpolaren, aprotischen Silylierungslösung. Sollen negative Strukturen erzeugt werden, wird die Resistschicht mit einer polaren, protischen Silylierungslösung behandelt.

Als Silylierungsagens dienen im allgemeinen Siliciumverbindungen in Form von Aminosilanen oder Aminosiloxanen; diese Verbindungen können oligomerer Natur sein. Bei der Erzeugung positiver Strukturen reagiert dabei beispielsweise ein Aminosiloxan - bei der Behandlung des durch eine Maske belichteten Resists - überraschenderweise nicht mit der in den belichteten Bereichen gebildeten Carbonsäure, d.h. es erfolgt nicht die an sich zu erwartende Säure-Base-Reaktion, es reagiert vielmehr mit dem Anhydrid in den unbelichteten Bereichen.

Die unpolaren, aprotischen Silylierungslösungen zur Erzeugung positiver Strukturen sind vorzugsweise organische Lösungen, d.h. Lösungen des Silylierungsagens in einem organischen Lösungsmittel. Vorteilhaft dienen als derartige Lösungsmittel Anisol, Dibutylether und/oder Diethylenglykoldimethylether; es können beispielsweise aber auch Toluol und Xylol sowie andere hochsiedende Lösungsmittel verwendet werden. Die zur Erzeugung negativer Strukturen eingesetzten polaren, protischen Silylierungslösungen sind vorzugsweise wäßrig-organische Lösungen des Silylierungsagens. Dabei wird das Silylierungsagens vorteilhaft in Gemischen von Wasser und Alkohol, insbesondere Ethanol und/ oder Isopropanol, gelöst; daneben können beispielsweise auch wassermischbare Ether zum Einsatz gelangen.

Beim erfindungsgemäßen Verfahren werden vorzugsweise solche Polymere eingesetzt, bei denen den Carbonsäureanhydridgruppen Maleinsäureanhydrid zugrunde liegt. Eine andere Verbindung dieser Art ist beispielsweise Itaconsäureanhydrid. Die Polymere können sowohl cyclische Anhydridfunktionen aufweisen, wobei diese in der Haupt- oder in der Seitenkette angeordnet sind, als auch nicht-cyclische, d.h. lineare Anhydridfunktionen. Eine Reihe von entsprechenden Monomeren sind aus der EP-OS 0 388 484 bekannt.

Den Carbonsäure-tert.-butylestergruppen liegt vorzugsweise Acrylsäure-, Methacrylsäure- oder Vinylbenzoesäure-tert.-butylester zugrunde. Andere Verbindungen dieser Art sind beispielsweise die tert.-Butylester von Maleinsäure, Fumarsäure, Itaconsäure und Zimtsäure.

Vorzugsweise finden beim erfindungsgemäßen Verfahren Copolymere aus Maleinsäureanhydrid und Acrylsäure-, Methacrylsäure- oder Vinylbenzoesäure-tert.-butylester Verwendung. Vorteilhaft können beispielsweise aber auch Terpolymere eingesetzt werden, die aus einen tert.-Butylester einer ungesättigten Carbonsäure, Maleinsäureanhydrid und Styrol enthaltenden Monomermischungen hergestellt werden.

Mischpolymere aus Carbonsäure-tert.-butylestern und Carbonsäureanhydriden, die beim erfindungsgemäßen Verfahren eingesetzt werden können, sind Gegenstand der deutschen Patentanmeldung Akt.Z. P 40 41 000.5 (entspricht EP-A-0 492 255) - "Mischpolymere". Die Mischpolymere können dabei nicht nur als Copolymere (der genannten Art) sondern auch als Terpolymere aufgebaut sein. In derartige Polymere ist zusätzlich eine ungesättigte Verbindung eingebaut, beispielsweise eine ungesättigte aromatische Verbindung, wie Styrol, α-Methylstyrol und Vinylnaphthalin.

Als Photoinitiator, der auch als Photosäure bezeichnet wird, können beim erfindungsgemäßen Verfahren an sich bekannte Verbindungen eingesetzt werden (siehe dazu beispielsweise EP-OS 0 102 450 und 0 234 327). Wichtig für die Auswahl des Photoinitiators ist allein die geforderte Eigenschaft, bei Belichtung eine Säure freizusetzen. Die Belichtung erfolgt dabei mit UV-Licht oder mit Elektronen- bzw. Röntgenstrahlen, wobei vorteilhaft eine starke Säure gebildet wird. Die Säure bewirkt dann eine Abspaltung des tert.-Butylesters aus der Carbonsäuretert.-butylestergruppe, und zwar bei einer der Belichtung folgenden Temperaturbehandlung.

Der Photoinitiator ist vorzugsweise eine Oniumverbindung. Derartige Verbindungen, die auch als Crivellosalze bezeichnet werden, sind beispielsweise Diphenyljodonium- und Triphenylsulfonium-triflat (mit Triflat wird der Trifluormethansulfonylrest bezeichnet). Weitere einsetzbare Photoinitiatoren sind beispielsweise Triazinderivate. Der Photoinitiator wird im allgemeinen in einer Konzentration von 1 bis 20 Masse-% eingesetzt, bezogen auf den trockenen Photoresist, d.h. die lösungsmittelfreie Resistzusammensetzung.

Als Lösungsmittel dienen an sich bekannte Resistlösungsmittel. Wichtig für die Auswahl des Lösungsmittels ist allein das Erfordernis, daß sowohl die Polymerkomponente als auch der Photoinitiator gelöst werden muß. Außerdem müssen - mit den bekannten Beschichtungsverfahren - fehlerfreie Resistschichten auf den Substraten gebildet werden, beispielsweise auf Siliciumwafern oder auf mit einem Bottomresist beschichteten Wafern. Vorzugsweise ist das Lösungsmittel Cyclohexanon oder Methoxypropylacetat; daneben gelangt beispielsweise auch Diethylenglykoldimethylether zum Einsatz.

Mittels des erfindungsgemäßen Verfahrens können sowohl positive als auch negative Strukturen hergestellt werden. Darüber hinaus kann dieses Verfahren sowohl bei der Einlagen- als auch bei der Zweilagenresisttechnik zum Einsatz gelangen. Das Verfahren bietet ferner die Möglichkeit einer Inspizierung, beispielsweise der Linienbreite, vor dem Ätzen, was sich als Vorteil bei der Fertigung erweist. Außerdem zeichnet sich dieses Verfahren, insbesondere im Vergleich zu den Verfahren nach den europäischen Patentanmeldungen Nr. 90107013.6 und 90108062.2, durch eine deutlich höhere Empfindlichkeit als auch durch eine deutlich höhere Ätzresistenz der silylierten Bereiche gegenüber reaktivem Ionenätzen im Sauerstoffplasma aus sowie durch eine deutlich bessere Silylierungsselektivität. Neben der hohen Empfindlichkeit von 1 bis 5 mJ/cm², insbesondere im DUV-Bereich, sind vor allem auch eine Auflösung im Subhalbmikron-Bereich und eine einfache Prozessierung in produktionsüblichen Apparaturen (bei Raumtemperatur und Normaldruck) weitere besondere Charakteristika des TSI-Systems nach der Erfindung.

Anhand von Ausführungsbeispielen soll die Erfindung noch näher erläutert werden. Dabei finden folgende Ausgangsmaterialien bzw. Reagenzien Verwendung (MT = Masseteile):
- Basispolymer (1):
   Copolymer aus p-Vinylbenzoesäure-tert.-butylester und Maleinsäureanhydrid, hergestellt durch radikalische Polymerisation der beiden Monomere in Toluol mit Azoisobuttersäurenitril als Initiator.
- Basispolymer (2):
   Copolymer aus Acrylsäure-tert.-butylester und Maleinsäureanhydrid, hergestellt durch radikalische Polymerisation der beiden Monomere in Toluol mit Azoisobuttersäurenitril als Initiator.
- Basispolymer (3):
   Copolymer aus Methacrylsäure-tert.-butylester und Maleinsäureanhydrid, hergestellt durch radikalische Polymerisation der beiden Monomere in Toluol mit Azoisobuttersäurenitril als Initiator.
- Photoaktive Komponente (1):
   Dies ist eine Verbindung, die bei Belichtung eine starke Säure bildet; geeignete Säurebildner sind insbesondere als Crivellosalze bekannte Oniumverbindungen sowie Triazinderivate; zum Einsatz gelangt hier Triphenylsulfonium-trifluormethansulfonat.
- Photoaktive Komponente (2):
   Der Säurebildner ist hierbei Diphenyljodonium-trifluormethansulfonat.
- Silylierungslösung (1):
   Organische Lösung, bestehend aus 5 MT Diaminosiloxan, 40 MT Dibutylether und 55 MT Anisol; vorzugsweise wird ein α,ω-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt).
- Silylierungslösung (2):
   Organische Lösung, bestehend aus 2 MT Diaminosiloxan (Tegomer A-Si 2120), 67,1 MT Dibutylether und 30,9 MT Diethylenglykoldimethylether.
- Silylierungslösung (3):
   Organische Lösung, bestehend aus 4 MT Diaminosiloxan (Tegomer A-Si 2120), 49,2 MT Dibutylether und 46,8 MT Anisol.
- Silylierungslösung (4):
   Wäßrig-organische Lösung, bestehend aus 1,3 MT Diaminosiloxan (Tegomer A-Si 2120), 50,4 MT Ethanol, 45,8 MT Isopropanol und 2,5 MT Wasser.
- Silylierungslösung (5):
   Wäßrig-organische Lösung, bestehend aus 1 MT Diaminosiloxan (Tegomer A-Si 2120), 94,3 MT Isopropanol und 4,7 MT Wasser.

### Beispiel 1

Auf einen Siliciumwafer wird ein Resist, bestehend aus 25,8 MT Basispolymer (1), 2,2 MT photoaktive Komponente (1) und 72 MT Methoxypropylacetat, aufgeschleudert und 60 s bei 100°C auf einer Hotplate getrocknet; die Schichtdicke des Resists beträgt 1,3 µm. Der Resist wird dann durch eine Maske mit 2,2 mJ/cm² kontaktbelichtet (Gerät MJB 3, Fa. Karl Süss; λ = 250 nm) und 60 s bei 110°C auf der Hotplate getempert. Danach wird der Resist in einer Puddle-Entwicklungsapparatur (Typ CEM 2000, Fa. Convac), bei Raumtemperatur und Normaldruck, 30 s mit der Silylierungslösung (1) behandelt und dann 30 s mit Dibutylether gespült und getrocknet. Nach dem Trocknen wird der Wafer in eine Plasmaätzanlage (Typ MIE 720, Fa. Material Research Corporation) gebracht und der Resist im Sauerstoffplasma trocken entwickelt (O₂/RIE: 1,8 mTorr Gasdruck, 30 sccm Gasfluß, 40 V Biasspannung, 0,9 kW Leistung, mit Magnet). Es werden positive Strukturen bis 0,4 µm mit senkrechten Flanken und einem Steg/Graben-Verhältnis von 1:1 erhalten.

### Beispiel 2

Auf einen Siliciumwafer wird ein Resist, bestehend aus 23,75 MT Basispolymer (2), 1,25 MT photoaktive Komponente (2) und 75 MT Diethylenglykoldimethylether, aufgeschleudert und 60 s bei 100°C auf einer Hotplate getrocknet; die Schichtdicke des Resists beträgt 1,2 µm. Der Resist wird dann durch eine Maske mit 0,9 mJ/cm² kontaktbelichtet (Gerät MJB 3, Fa. Karl Süss; λ= 250 nm) und 60 s bei 110°C auf der Hotplate getempert. Danach wird der Resist in einer Puddle-Entwicklungsapparatur (Typ CEM 2000-U, Fa. Convac), bei Raumtemperatur und Normaldruck, 20 s mit der Silylierungslösung (2) behandelt und dann 30 s mit Dibutylether gespült und getrocknet. Nach dem Trocknen wird der Resist in einer Plasmaätzanlage (Typ MIE 720, Fa. Material Research Corporation) im Sauerstoffplasma - entsprechend Beispiel 1 - trocken entwickelt. Es werden positive Strukturen bis 0,4 µm mit senkrechten Flanken und einem Steg/Graben-Verhältnis von 1:1 erhalten.

### Beispiel 3

Auf einen Siliciumwafer (als Substrat) wird ein käuflicher Positivresist auf Novolak-Basis aufgeschleudert und 1 min bei 90°C getrocknet; dann wird 35 min im Umluftofen bei 240°C ausgeheizt. Nach dem Ausheizen beträgt die Dicke des als Planarisierungsschicht dienenden Resists 1,3 µm.

Auf die Planarisierungsschicht wird ein Photoresist, bestehend aus 11,16 MT Basispolymer (3), 0,84 MT photoaktive Komponente (1) und 88 MT Methoxypropylacetat, aufgeschleudert. Nach Trocknung bei 100°C/60 s auf einer Hotplate beträgt die Schichtdicke dieses Topresists 0,3 µm. Der Resist wird dann durch eine Maske mit 0,7 mJ/cm² kontaktbelichtet (Gerät MJB 3, Fa. Karl Süss; λ = 250 nm) und 60 s bei 110°C auf der Hotplate getempert. Danach wird der Resist in einer Puddle-Entwicklungsapparatur (Typ CEM 2000, Fa. Convac), bei Raumtemperatur und Normaldruck, 45 s mit der Silylierungslösung (3) behandelt und dann 30 s mit Dibutylether gespült und getrocknet. Nach dem Trocknen wird der Resist in einer Plasmaätzanlage (Typ MIE 720, Fa. Material Research Corporation) im Sauerstoffplasma - entsprechend Beispiel 1 - trocken entwickelt. Es werden positive Strukturen bis 0,4 µm mit senkrechten Flanken und einem Steg/Graben-Verhältnis von 1:1 erhalten.

### Beispiel 4

Es wird wie in Beispiel 3 vorgegangen, die Belichtung (durch eine Maske) erfolgt jedoch mittels eines DUV-Steppers (Canon Excimer Laser Stepper FPA 4500; λ = 248 nm, NA = 0,37). Die für 1:1-Abbildungen benötigte Dosis ist bei Verwendung dieses Belichtungsgerätes deutlich höher als bei der Kontaktbelichtung entsprechend Beispiel 3 und beträgt im vorliegenden Fall 3,9 mJ/cm². Nach der Trockenentwicklung werden positive Strukturen bis 0,3 µm mit einem Steg/Graben-Verhältnis von 1:1 und maßhaltige Kontaktlöcher bis 0,4 µm erhalten; Strukturen und Kontaktlöcher haben senkrechte Flanken.

### Beispiel 5

Es wird wie in Beispiel 2 vorgegangen, die Trockenentwicklung in der Plasmaätzanlage erfolgt jedoch in einem Zweistufenprozeß. Dabei wird zunächst 6 s mit einem Plasma geätzt, das neben Sauerstoff (O₂) noch Tetrafluormethan (CF₄) enthält (O₂-Fluß: 80 sccm; CF₄-Fluß: 9 sccm; Gesamtgasdruck: 8,1 mTorr; Biasspannung: 40 V; mit Magnet). Anschließend wird im reinen O₂-Plasma geätzt (Gesamtgasdruck: 1,9 mTorr; Biasspannung: 50 V; mit Magnet). Es werden Strukturen bis 0,4 µm mit senkrechten Flanken und einem Steg/Graben-Verhältnis von 1:1 erhalten.

### Beispiel 6

Ein Resist entsprechend Beispiel 3 wird in der dort beschriebenen Weise auf einen Siliciumwafer aufgebracht und getrocknet. Die gesamte Oberfläche des Resists wird dann mit 1,5 mJ/cm² belichtet (Gerät MJB 3, Fa. Karl Süss; λ = 250 nm), anschließend wird 60 s bei 110°C getempert. Nach dem Abkühlen wird - in entsprechender Weise - 60 s in einer Puddle-Entwicklungsapparatur mit der Silylierungslösung (3) behandelt, dann wird 30 s mit Dibutylether gespült und getrocknet. Nach dem Trocknen wird der Wafer in eine Plasmaätzanlage (Typ MIE 720, Fa. Material Research Corporation) gebracht und der Resist 200 s im Sauerstoffplasma trocken geätzt (O₂/RIE: 1,8 mTorr Gasdruck, 30 sccm Gasfluß, 40 V Biasspannung, 0,9 kW Leistung, mit Magnet). Aus der Schichtdickenmessung vor und nach der Ätzung errechnet sich eine Abtragsrate der silylierten Schicht von 0,69 nm/s.

Werden Resists entsprechend der europäischen Patentanmeldung Nr. 90107013.6 (aus einem chemisch reaktive Gruppen, insbesondere Anhydridgruppen, enthaltenden Polymer und einer photoaktiven Komponente auf der Basis von Diazoketon oder Chinondiazid) wie dort angegeben silyliert (siehe die entsprechenden Ausführungsbeispiele) und die silylierten Schichten unter den vorstehend beschriebenen Bedingungen geätzt, dann werden - bei den silylierten Schichten - Abtragsraten gemessen, die in allen Fällen zwischen 0,95 und 1,05 nm/s liegen. Die im Rahmen der vorliegenden Patentanmeldung erzeugten siliciumhaltigen Schichten zeigen - im Vergleich dazu - im allgemeinen eine ca. 30 % höhere Ätzresistenz bei der Trockenentwicklung im Sauerstoffplasma (O₂/RIE).

### Beispiel 7

Entsprechend Beispiel 3 wird ein Photoresist auf eine Planarisierungsschicht aufgebracht; die Schichtdicke dieses Topresists beträgt - nach der Trocknung bei 90°C/60 s - 0,3 µm. Der Resist wird dann durch eine Maske mit 1,6 mJ/cm² kontaktbelichtet (Gerät MJB 3, Fa. Karl Süss; λ = 250 nm) und 60 s bei 100°C auf der Hotplate getempert. Danach werden die belichteten Bereiche in einer Puddle-Entwicklungsapparatur (Typ CEM 2000, Fa. Convac), bei Raumtemperatur und Normaldruck, durch Behandeln mit der Silylierungslösung (4) - für die Dauer von 25 s - hoch selektiv silyliert, dann wird 30 s mit Isopropanol gespült und getrocknet. Die Silylierung führt in den belichteten Bereichen zu einem Schichtzuwachs von über 250 nm, während in den unbelichteten Bereichen kein meßbarer Zuwachs erfolgt. Nach dem Trocknen wird der Wafer in eine Plasmaätzanlage (Typ MIE 720, Fa. Material Research Corporation) gebracht und der Resist im Sauerstoffplasma trocken entwickelt (O₂/RIE: 1,8 mTorr Gasdruck, 30 sccm Gasfluß, 40 V Biasspannung, 0,9 kW Leistung, mit Magnet). Es werden negative Strukturen bis 0,4 µm mit senkrechten Flanken und einem Steg/Graben-Verhältnis von 1:1 erhalten.

### Beispiel 8

Es wird wie in Beispiel 7 vorgegangen, die Belichtung (durch eine Maske) erfolgt jedoch mittels eines DUV-Steppers (Canon Excimer Laser Stepper FPA 4500; λ = 248 nm, NA = 0,37). Die für 1:1-Abbildungen benötigte Dosis ist bei Verwendung dieses Belichtungsgerätes deutlich höher als bei der Kontaktbelichtung entsprechend Beispiel 7 und beträgt im vorliegenden Fall 9,5 mJ/cm². Nach der Trockenentwicklung werden negative Strukturen bis 0,3 µm mit einem Steg/Graben-Verhältnis von 1:1 und maßhaltige Kontaktlöcher bis 0,4 µm erhalten; Strukturen und Kontaktlöcher haben einen Flankenwinkel von 90°.

### Beispiel 9

Es wird wie in Beispiel 2 vorgegangen, der Resist wird jedoch mit 1,3 mJ/cm² belichtet; die Silylierung in der Puddle-Entwicklungsapparatur (Raumtemperatur, Normaldruck) erfolgt mit der Silylierungslösung (5) für die Dauer von 40 s. Nach einer entsprechenden Trockenentwicklung im Sauerstoffplasma werden negative Strukturen bis 0,4 µm mit senkrechten Flanken und einem Steg/Graben-Verhältnis von 1:1 erhalten.

### Beispiel 10

Entsprechend Beispiel 2 wird ein Resist auf einen Siliciumwafer aufgebracht und getrocknet. Die gesamte Oberfläche des Resists wird dann mit 1,5 mJ/cm² belichtet (Gerät MJB 3, Fa. Karl Süss; λ = 250 nm), anschließend wird 60 s bei 110°C getempert. Nach dem Abkühlen wird - in entsprechender Weise wie in Beispiel 3 - 120 s in einer Puddle-Entwicklungsapparatur mit der Silylierungslösung (5) behandelt, dann wird 30 s mit Isopropanol gespült und getrocknet. Nach dem Trocknen wird der Resist entsprechend Beispiel 6 trocken geätzt. Aus der Schichtdickenmessung vor und nach der Ätzung errechnet sich eine Abtragsrate der silylierten Schicht von 0,67 nm/s.

Werden Resists entsprechend der europäischen Patentanmeldung Nr. 90108062.2 (aus einem Anhydridgruppen und blockierte Imid- oder phenolische Hydroxylgruppen enthaltenden Polymer und einer photoaktiven Komponente in Form einer bei Belichtung eine starke Säure bildenden Verbindung) wie dort angegeben silyliert (siehe die entsprechenden Ausführungsbeispiele) und die silylierten Schichten unter den vorstehend beschriebenen Bedingungen geätzt, dann werden - bei den silylierten Schichten - Abtragsraten gemessen, die in allen Fällen zwischen 0,95 und 1,05 nm/s liegen. Die im Rahmen der vorliegenden Patentanmeldung erzeugten siliciumhaltigen Schichten zeigen - im Vergleich dazu - im allgemeinen eine ca. 30 % höhere Ätzresistenz bei der Trockenentwicklung im Sauerstoffplasma (O₂/RIE).

## Patentansprüche

1. Verfahren zur photolithographischen Strukturerzeugung im Submikron-Bereich, **dadurch gekennzeichnet**, daß
- auf ein Substrat eine Photoresistschicht aus einem Carbonsäureanhydrid- und Carbonsäure-tert.-butylestergruppen enthaltenden Polymer, einem bei Belichtung eine Säure freisetzenden Photoinitiator und einem geeigneten Lösungsmittel aufgebracht wird,
- die Photoresistschicht getrocknet wird,
- die Photoresistschicht bildmäßig belichtet wird,
- die belichtete Photoresistschicht einer Temperaturbehandlung ausgesetzt wird,
- die derart behandelte Photoresistschicht einer Flüssigsilylierung unterworfen wird und
- die silylierte Photoresistschicht in einem anisotropen Sauerstoffplasma trocken entwickelt wird,
wobei die Temperaturbehandlung so geführt wird, daß der Photoresist in den belichteten Bereichen hydrophil wird.

2. Verfahren nach Anspruch 1, **dadurch gekennzeichnet**, daß die Temperaturbehandlung im Bereich zwischen 80 und 140°C für die Dauer von 15 bis 200 s erfolgt.

3. Verfahren nach Anspruch 1 oder 2, **dadurch gekennzeichnet**, daß die Flüssigsilylierung mit einer unpolaren, aprotischen Silylierungslösung erfolgt.

4. Verfahren nach Anspruch 3, dadurch **gekennzeichnet**, daß als Silylierungslösung eine Lösung eines Aminosiloxans in einem organischen Lösungsmittel, insbesondere Anisol, Dibutylether und/oder Diethylenglykoldimethylether, verwendet wird.

5. Verfahren nach Anspruch 1 oder 2, **dadurch gekennzeichnet**, daß die Flüssigsilylierung mit einer polaren, protischen Silylierungslösung erfolgt.

6. Verfahren nach Anspruch 5, **dadurch gekennzeichnet**, daß als Silylierungslösung eine Lösung eines Aminosiloxans in einem Gemisch von Wasser und Alkohol, insbesondere Ethanol und/oder Isopropanol, verwendet wird.

7. Verfahren nach einem oder mehreren der Ansprüche 1 bis 6, **dadurch gekennzeichnet** daß ein Polymer verwendet wird, dessen Carbonsäureanhydridgruppen Maleinsäureanhydrid zugrunde liegt.

8. Verfahren nach einem oder mehreren der Ansprüche 1 bis 7, **dadurch gekennzeichnet**, daß ein Polymer verwendet wird, dessen Carbonsäure-tert.-butylestergruppen Acrylsäure-, Methacrylsäure- oder Vinylbenzoesäure-tert.-butyl-ester zugrunde liegt.

9. Verfahren nach Anspruch 7 oder 8, **dadurch gekennzeichnet**, daß ein Copolymer aus Maleinsäureanhydrid und Acrylsäure-, Methacrylsäure- oder Vinylbenzoesäure-tert.-butylester verwendet wird.

10. Verfahren nach einem oder mehreren der Ansprüche 1 bis 9, **dadurch gekennzeichnet**, daß als Photoinitiator eine Oniumverbindung verwendet wird.

## Claims

1. A method for the photolithographic production of structures in the sub-micron range, characterised in that
- a photoresist layer, consisting of a polymer containing carboxylic acid anhydride- and carboxylic acid tert. butyl ester groups, a photoinitiator which releases an acid upon exposure and a suitable solvent, is applied to a substrate,
- the photoresist layer is dried,
- the photoresist layer is exposed patternwise,
- the exposed photoresist layer is subjected to a thermal treatment,
- the photoresist layer treated in this way is subjected to liquid silylation and
- the silylated photoresist layer is dry-developed in an anisotropic oxygen plasma,
wherein the thermal treatment is conducted in such manner that the photoresist becomes hydrophilic in the exposed areas.

2. A method as claimed in Claim 1, characterised in that the thermal treatment takes place in the range between 80 and 140°C for a period of 15 to 200 s.

3. A method as claimed in Claim 1 or 2, characterised in that the liquid silylation takes place using a nonpolar, aprotic silylation solution.

4. A method as claimed in Claim 3, characterised in that a solution of an aminosiloxane in an organic solvent, in particular anisole, dibutyl ether and/or diethylene glycol dimethyl ether, is used as silylation solution.

5. A method as claimed in Claim 1 or 2, characterised in that the liquid silylation takes place using a polar, protic silylation solution.

6. A method as claimed in Claim 5, characterised in that a solution of an aminosiloxane in a mixture of water and alcohol, in particular ethanol and/or isopropanol, is used as silylation solution.

7. A method as claimed in one or more of Claims 1 to 6, characterised in that a polymer is used whose carboxylic acid anhydride groups are based on maleic acid anhydride.

8. A method as claimed in one or more of Claims 1 to 7, characterised in that a polymer is used whose carboxylic acid tert. butyl ester groups are based on acrylic acid-, methacrylic acid- or vinyl benzoic acid tert. butyl ester.

9. A method as claimed in Claim 7 or 8, characterised in that a copolymer of maleic acid anhydride and acrylic acid-, methacrylic acid- or vinyl benzoic acid tert. butyl ester is used.

10. A method as claimed in one or more of Claims 1 to 9, characterised in that an onium compound is used as photoinitiator.

## Revendications

1. Procédé de création de structures par voie photolithographique dans la plage du sous-micron, **caractérisé en ce que**
- une couche d'une photoréserve constituée d'un polymère contenant des groupes d'anhydride d'acide carboxylique et de tert-butylester d'acide carboxylique, d'un photoinitiateur libérant un acide sous exposition et d'un solvant approprié, est dépotée sur un substrat,
- la couche de la photoréserve est séchée,
- la couche de la photoréserve est soumise à une exposition photographique,
- la couche de la photoréserve exposée fait l'objet d'un traitement thermique,
- la couche de la photoréserve ainsi traitée est soumise à une silylation liquide et
- la couche de la photoréserve silylatée est développée à sec dans un plasma à l'oxygène anisotrope, le traitement thermique étant conduit de telle manière que la photoréserve soit hydrophile dans les zones exposées.

2. Procédé selon la revendication 1, **caractérisé en ce que** le traitement thermique s'effectue dans une plage comprise entre 80^{º} et 140^{º} C pour une durée de 15 à 200 s.

3. Procédé selon la revendication 1 ou 2, **caractérisé en ce que** la silylation liquide s'effectue avec une solution de silylation aprotique non polaire.

4. Procédé selon la revendication 3, **caractérisé en ce que** dans un solvant organique, notamment l'anisol, le dibutylether et/ou le diéthylèneglycoldiméthyléther une solution d'un aminosiloxane est utilisée comme solution de silylation.

5. Procédé selon la revendication 1 ou 2, **caractérisé en ce que** la silylation liquide s'effectue avec une solution de silylation protique polaire.

6. Procédé selon la revendication 5, **caractérisé en ce que** dans un mélange d'eau et d'alcool, notamment l'éthanol et/ou l'isopropanol une solution d'un aminosiloxane est utilisée comme solution de silylation.

7. Procédé selon l'une ou plusieurs des revendications 1 à 6, **caractérisé en ce que** un polymère est utilisé dont les groupes de l'anhydride d'acide carboxylique sont à base d'anhydride de l'acide maléique.

8. Procédé selon l'une ou plusieurs des revendications 1 à 7, **caractérisé en ce que** un polymère est utilisé dont les groupes tert.-butylester de l'acide carboxylique sont à base de tert.-butylester d'acide acrylique, d'acide méthacrylique ou d'acide vinylbenzoique.

9. Procédé selon la revendication 7 ou 8, **caractérisé en ce que** un copolymère constitué d'anhydride de l'acide maléique et de tert.-butylester d'acide acrylique, d'acide méthacrylique ou d'acide vinylbenzoique est utilisé.

10. Procédé selon l'une ou plusieurs des revendications 1 à 9, **caractérisé en ce que** un composé d'onium est utilisé comme photoinitiateur.
